# EUROPEAN PATENT APPLICATION

(11) **EP 4 848 135 A2**
(43) Date of publication of application: **02.12.2026**
(21) Application number: 26180722.6
(22) Date of filing: 22.05.2026
(51) Int. Cl.: G06F 30/27, G06N 3/006, G06N 5/022

(54) **AUTOMATED GENERATION OF CHEMICAL PROCESS ENGINEERING SCHEMATICS IN INDUSTRIAL PROCESS DESIGN**

(30) Priority: 29.05.2025 IN 202521052124
(71) Applicant: Tata Consultancy Services Limited, Maharashtra (IN)
(72) Inventor: GUPTA, Shivam, 201309 Noida, Uttar Pradesh (IN); SAKHINANA, Sagar Srinivas, 560066 Bangalore, Karnataka (IN); DAS, Akash, 560066 Bangalore, Karnataka (IN); RUNKANA, Venkataramana, 411028 Pune, Maharashtra (IN)
(74) Representative: Goddar, Heinz J.

(57) **Abstract**

Existing methods are not designed to auto-generate PFDs or PIDs for industrial-scale chemical production processes. The present disclosure retrieves a context from a Memory database and a Graph database, based on a filtered query being received, using one or more fine-tuned Small Language Models (SLMs). The proposed approach of the present disclosure yields robust performance on complex reasoning tasks and demonstrates effective generalization via the generation of plausible, simulator-validated process descriptions for previously unseen chemicals. Further an initial enhanced response is generated using a test-time inference scaling, based on the retrieved context. Furthermore, the following steps are performed iteratively till a predefined number of iterations. The generated initial enhanced response is evaluated and refined, by a Critique-Agent, using one or more feedback mechanisms which include a SLM-as-a-judge and a Reward-model-as-a-judge. A final response to the query is generated, based on the refinement.

## Description

### CROSS-REFERENCE TO RELATED APPLICATIONS AND PRIORITY

The present application claims priority to Indian application no. 202521052124, filed on May 29, 2025.

### TECHNICAL FIELD

The disclosure herein generally relates to chemical process engineering, and, more particularly, to an automated generation of chemical process engineering schematics in industrial process design.

### BACKGROUND

Process Flow Diagrams (PFDs) and Piping and Instrumentation Diagrams (PIDs) are standard engineering diagrams in the chemical process industry. A PFD provides a high-level schematic (or layout) of the flow of materials and energy through a chemical production process. It depicts major equipment, process streams, and key operating conditions for specific equipment within the process, without delving into instrumentation or control details for plant operation. PIDs, which are built upon PFDs, provide a more detailed schematic of the instrumentation and control systems that are essential for monitoring, operational control, safety, and maintenance of the chemical process plant.

Recent advancements in generative AI are transforming chemical and materials science by accelerating the autonomous discovery of environmentally friendly, next-generation specialty chemicals and the development of low-cost, high-performance materials-based products. At the same time, these advancements are enhancing complex first-principles simulation workflows and reducing reliance on tedious lab trial-and-error, enabling faster innovation, lower Research & Development (R&D) costs, and more sustainable chemical and material development. However, these approaches require the development of new production processes to transition novel discoveries from computer simulations or wet-lab experiments to industrial-scale production - a significant challenge in bringing better products to market faster.

### SUMMARY

Embodiments of the present disclosure present technological improvements as solutions to one or more of the above-mentioned technical problems recognized by the inventors in conventional systems. For example, in one embodiment, a method for automated generation of chemical process engineering schematics in industrial process design is provided. The method includes receiving, via one or more hardware processors, a query specific to at least one of a process flow diagram and a piping and instrumentation diagram description, from a user; filtering, via the one or more hardware processors, the received query by passing through guardrails of one or more Large Language Models (LLMs), if the received user query includes an irrelevant information; retrieving, via the one or more hardware processors, a context from a Memory database and a Graph database, based on the filtered query, using one or more fine-tuned Small Language Models (SLMs); generating, via the one or more hardware processors, an initial enhanced response using a test-time inference scaling, wherein the test-time inference scaling comprises: generating, via the one or more fine-tuned SLMs a plurality of diverse candidate responses based on the query and the retrieved context; selecting an improved preferred candidate response from the plurality of diverse candidate responses based on at least one of a confidence-weighted entropy scoring or a self-reflection based revision to enhance a factual accuracy and a reliability of the initial enhanced response; and generating the initial enhanced response based on the improved preferred candidate response; performing iteratively, via the one or more hardware processors, till a predefined number of iterations: evaluating, by using a Critique-Agent, the generated initial enhanced response, using one or more feedback mechanisms which includes:providing, by using a SLM-as-a-judge, a first feedback including an identification of one or more potential errors, one or more inconsistencies, or one or more areas of improvement in the generated initial enhanced response; and providing, by using a Reward-model-as-a-judge, a second feedback including a scalar score reflecting the quality of the generated initial enhanced response; refining, via the one or more hardware processors, the generated initial enhanced response based on at least one of the first feedback from the SLM-as-a-judge and the second feedback from the Reward-model-as-a-judge; and generating, via the one or more hardware processors, a final response to the query, based on the refinement.

In another aspect, there is provided a system for automated generation of chemical process engineering schematics in industrial process design. The system comprises: a memory storing instructions; one or more communication interfaces; and one or more hardware processors coupled to the memory via the one or more communication interfaces, wherein the one or more hardware processors are configured by the instructions to: receive a query specific to at least one of a process flow diagram and a piping and instrumentation diagram description, from a user. The system includes filtering the received query by passing through guardrails of one or more Large Language Models (LLMs), if the received user query includes an irrelevant information; retrieving a context from a Memory database and a Graph database, based on the filtered query, using one or more fine-tuned Small Language Models (SLMs); generating an initial enhanced response using a test-time inference scaling, wherein the test-time inference scaling comprises: generating, via the one or more fine-tuned SLMs a plurality of diverse candidate responses based on the query and the retrieved context; selecting an improved preferred candidate response from the plurality of diverse candidate responses based on at least one of a confidence-weighted entropy scoring or a self-reflection based revision to enhance a factual accuracy and a reliability of the initial enhanced response; and generating the initial enhanced response based on the improved preferred candidate response; performing iteratively, till a predefined number of iterations: evaluating, by using a Critique-Agent, the generated initial enhanced response, using one or more feedback mechanisms which includes:providing, by using a SLM-as-a-judge, a first feedback including an identification of one or more potential errors, one or more inconsistencies, or one or more areas of improvement in the generated initial enhanced response; and providing, by using a Reward-model-as-a-judge, a second feedback including a scalar score reflecting the quality of the generated initial enhanced response; refining the generated initial enhanced response based on at least one of the first feedback from the SLM-as-a-judge and the second feedback from the Reward-model-as-a-judge; and generating a final response to the query, based on the refinement.

In yet another aspect, there are provided one or more non-transitory machine-readable information storage mediums comprising one or more instructions which when executed by one or more hardware processors cause receiving a query specific to at least one of a process flow diagram and a piping and instrumentation diagram description, from a user; filtering the received query by passing through guardrails of one or more Large Language Models (LLMs), if the received user query includes an irrelevant information; retrieving a context from a Memory database and a Graph database, based on the filtered query, using one or more fine-tuned Small Language Models (SLMs); generating an initial enhanced response using a test-time inference scaling, wherein the test-time inference scaling comprises: generating, via the one or more fine-tuned SLMs a plurality of diverse candidate responses based on the query and the retrieved context; selecting an improved preferred candidate response from the plurality of diverse candidate responses based on at least one of a confidence-weighted entropy scoring or a self-reflection based revision to enhance a factual accuracy and a reliability of the initial enhanced response; and generating the initial enhanced response based on the improved preferred candidate response; performing iteratively, till a predefined number of iterations: evaluating, by using a Critique-Agent, the generated initial enhanced response, using one or more feedback mechanisms which includes:providing, by using a SLM-as-a-judge, a first feedback including an identification of one or more potential errors, one or more inconsistencies, or one or more areas of improvement in the generated initial enhanced response; and providing, by using a Reward-model-as-a-judge, a second feedback including a scalar score reflecting the quality of the generated initial enhanced response; refining the generated initial enhanced response based on at least one of the first feedback from the SLM-as-a-judge and the second feedback from the Reward-model-as-a-judge; and generating a final response to the query, based on the refinement.

It is to be understood that both the foregoing general description and the following detailed description are exemplary and explanatory only and are not restrictive of the invention, as claimed.

### BRIEF DESCRIPTION OF THE DRAWINGS

The accompanying drawings, which are incorporated in and constitute a part of this disclosure, illustrate exemplary embodiments and, together with the description, serve to explain the disclosed principles:

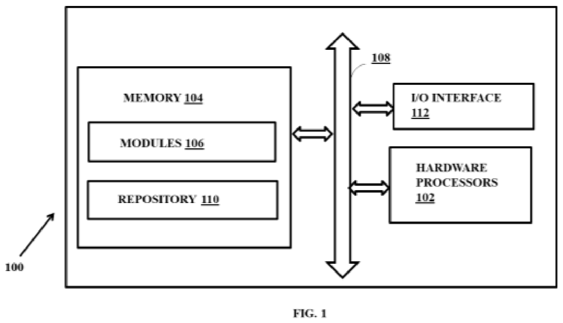

FIG. 1 illustrates an exemplary system for automated generation of chemical process engineering schematics in industrial process design, according to some embodiments of the present disclosure.

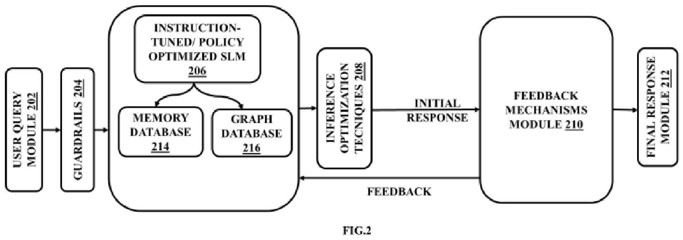

FIG. 2 is a functional block diagram of the system of FIG. 1 for automated generation of chemical process engineering schematics in industrial process design, according to some embodiments of the present disclosure.

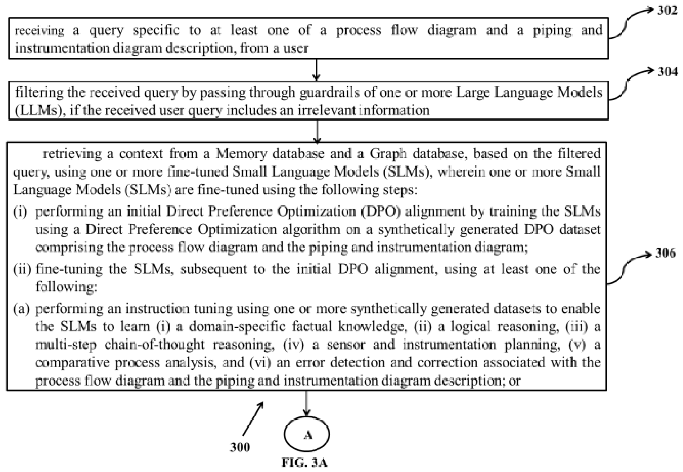

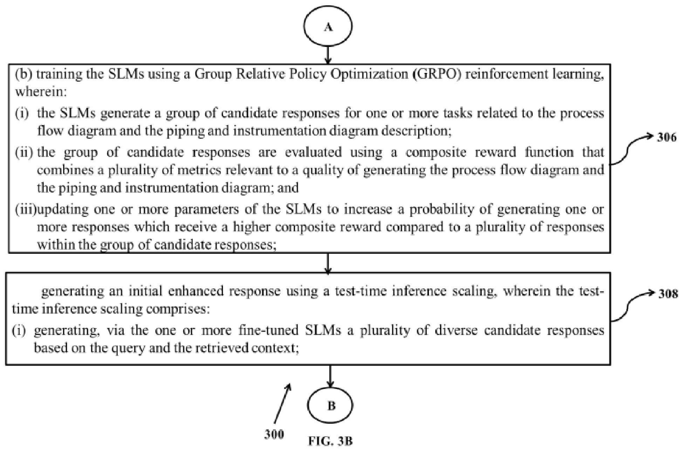

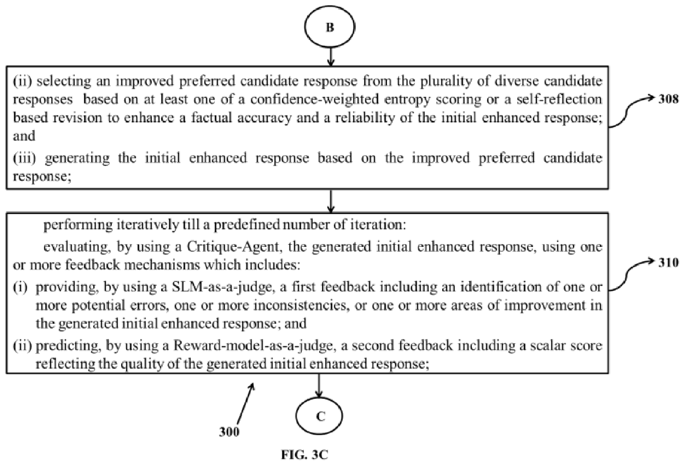

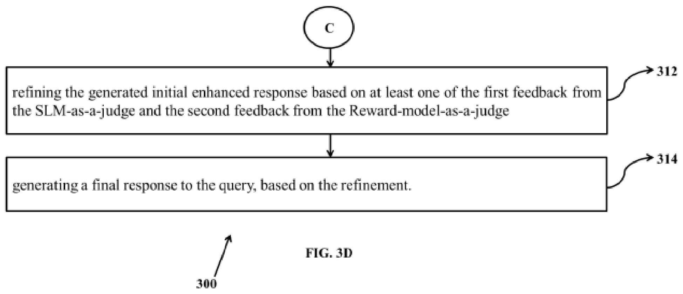

FIGS. 3A through 3D are flow diagrams illustrating the steps involved in the method for automated generation of chemical process engineering schematics in industrial process design, according to some embodiments of the present disclosure.

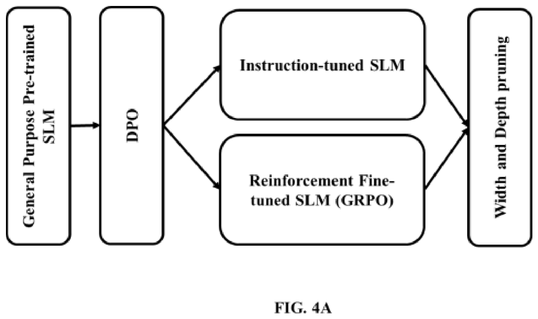

FIG.4A illustrates the Small Language Model (SLM) fine-tuning pipeline depicting initial Direct Preference Optimization (DPO) (known in the art) alignment followed by an instruction tuning or a Group Relative Policy Optimization (GRPO) reinforcement learning (known in the art), concluding with optional width/depth pruning, according to some embodiments of the present disclosure.

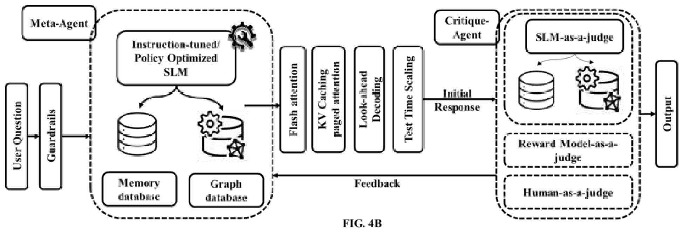

FIG. 4B illustrates an operational Retrieval-Augmented Generation (RAG) (known in the art) framework in conjunction with the method for automated generation of chemical process engineering schematics in industrial process design, according to some embodiments of the present disclosure.

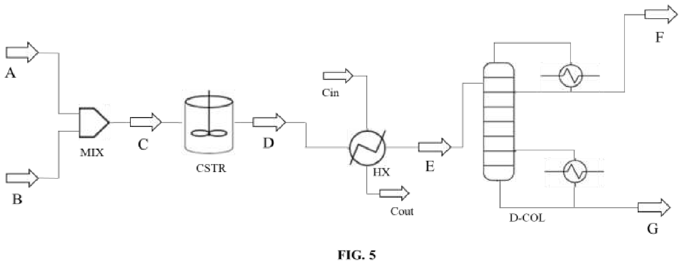

FIG. 5 illustrates a high-level schematic of a chemical process showing the material flow from reactant inlets (A and B) through a mixer (MIX), a continuous stirred-tank reactor (CSTR), a heat exchanger (HX-1), and a distillation column (D-COL) producing streams F and G, according to some embodiments of the present disclosure.

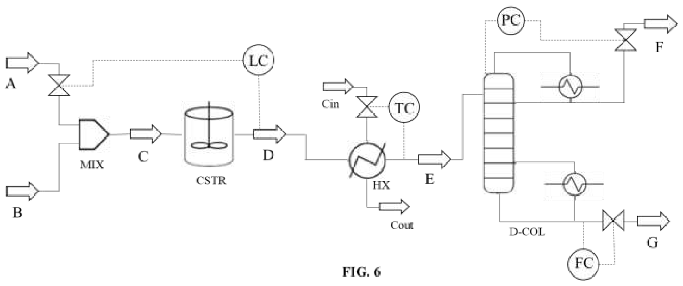

FIG. 6 illustrates a Piping and Instrumentation Diagram (P&ID) detailed representation of the chemical process, including sensors, control valves, and feedback loop, according to some embodiments of the present disclosure.

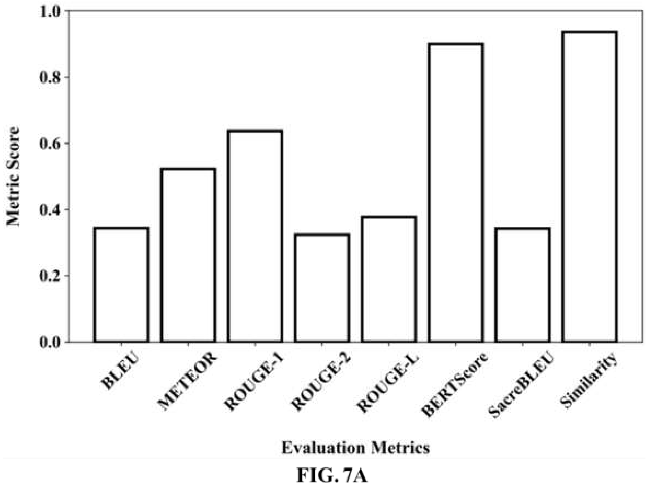

FIG. 7A illustrates a generative AI model (e.g., Llama-3.2-1B (Large Language Model Meta AI - 3.2 -1 Billion)) evaluated on the test splits of the Factual QA (Question-Answer) dataset (known in the art), SynDIP dataset (known in the art), and LogiCore dataset (known in the art), after Supervised Fine-Tuning (SFT) on the corresponding train splits, according to some embodiments of the present disclosure.

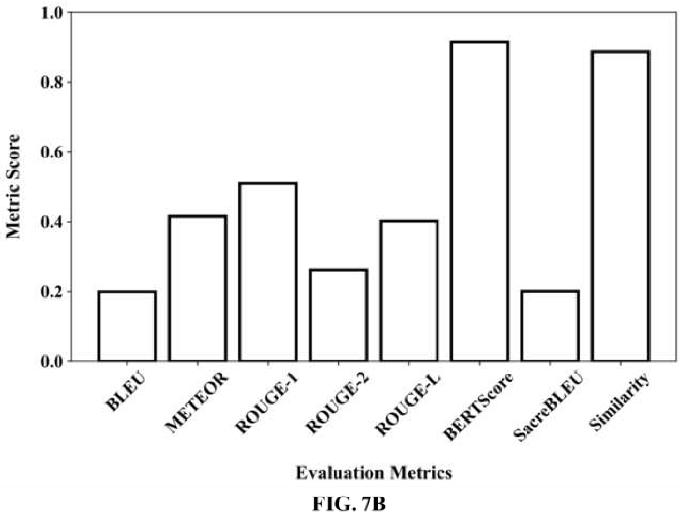

FIG. 7B illustrates the generative AI model (e.g., Llama-3.2-1B (Large Language Model Meta AI - 3.2 -1 Billion)) evaluated on the DPO test split, after fine-tuning on the corresponding train set using Direct Preference Optimization (DPO) (known in the art), according to some embodiments of the present disclosure.

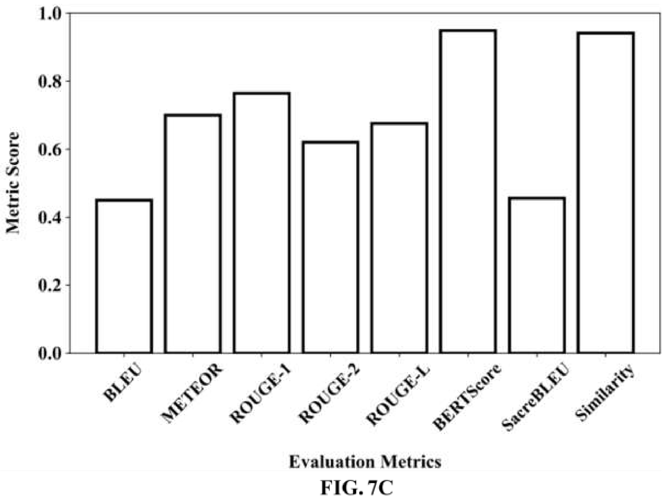

FIG. 7C illustrates the generative AI model (e.g., Llama-3.2-1B (Large Language Model Meta AI - 3.2 -1 Billion)) evaluated on the test splits of the Local dataset (known in the art) and Global RAIT dataset (known in the art), after fine-tuning on the respective train splits using Retrieval-Augmented Instruction Tuning (RAIT) (known in the art), according to some embodiments of the present disclosure.

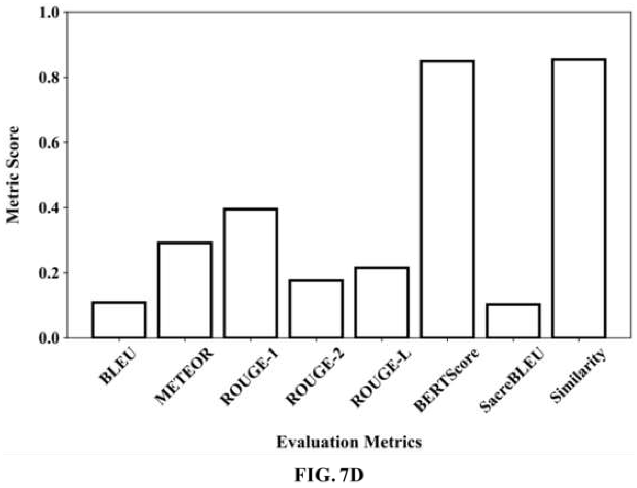

FIG. 7D illustrates a generative AI model (e.g., SmolLM-135M) evaluated on the test splits of the Factual QA dataset (known in the art), SynDIP dataset (known in the art), and LogiCore dataset (known in the art), after Supervised Fine-Tuning (SFT) on the corresponding train splits, according to some embodiments of the present disclosure.

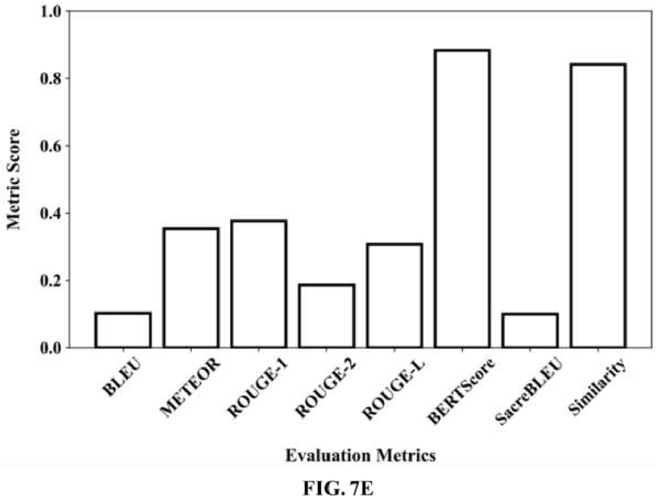

FIG. 7E illustrates the generative AI model (e.g., SmolLM-135M (Smol Language Model)) evaluated on the DPO (known in the art) test split, after fine-tuning on the corresponding train split using Direct Preference Optimization (DPO) dataset (known in the art), according to some embodiments of the present disclosure.

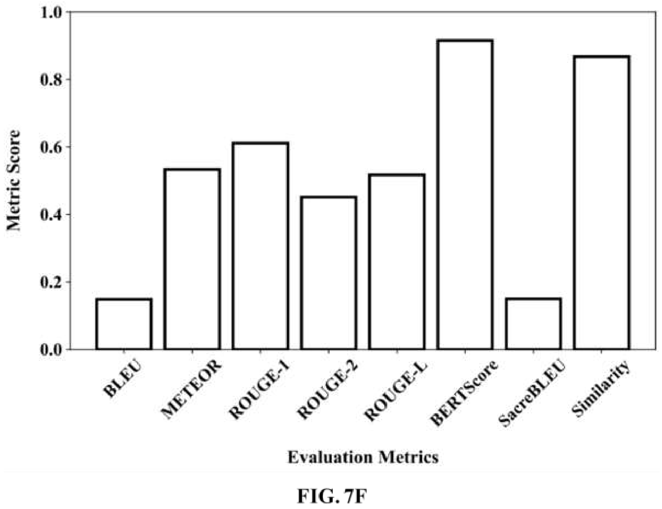

FIG. 7F illustrates the generative AI model (e.g., SmolLM-135M) evaluated on the test splits of the Local dataset (known in the art) and Global RAIT dataset (known in the art), after fine-tuning on the respective train splits using Retrieval-Augmented Instruction Tuning (RAIT) (known in the art), according to some embodiments of the present disclosure.

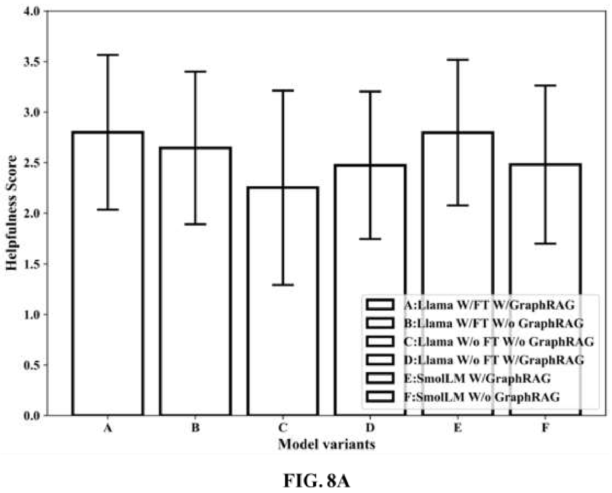

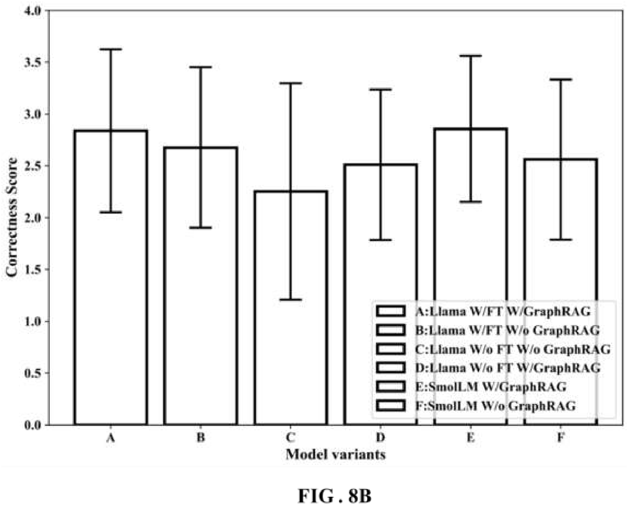

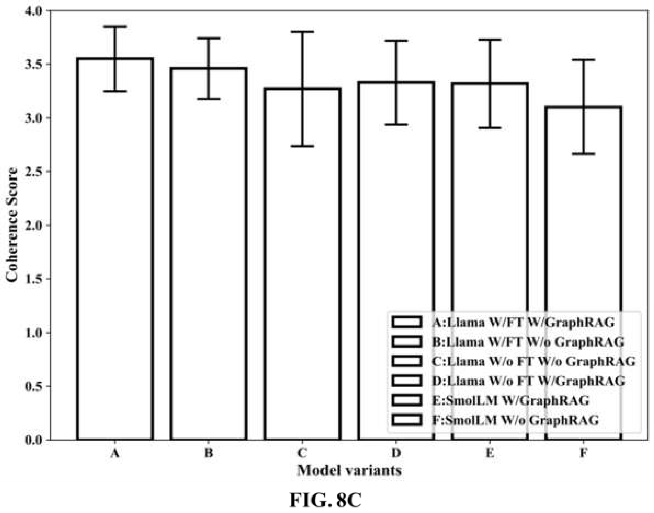

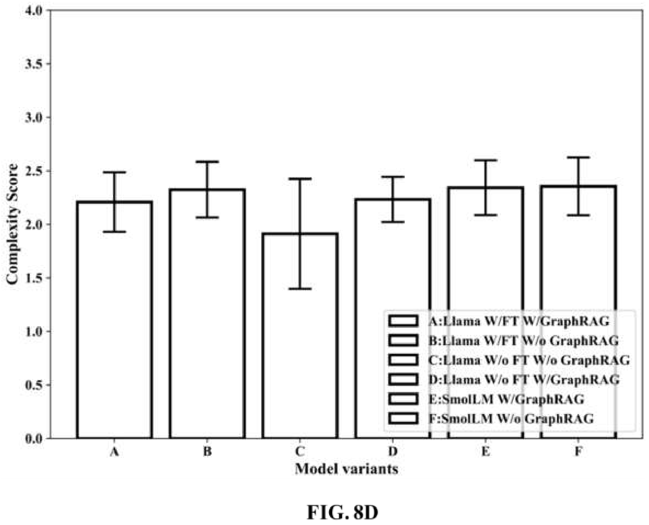

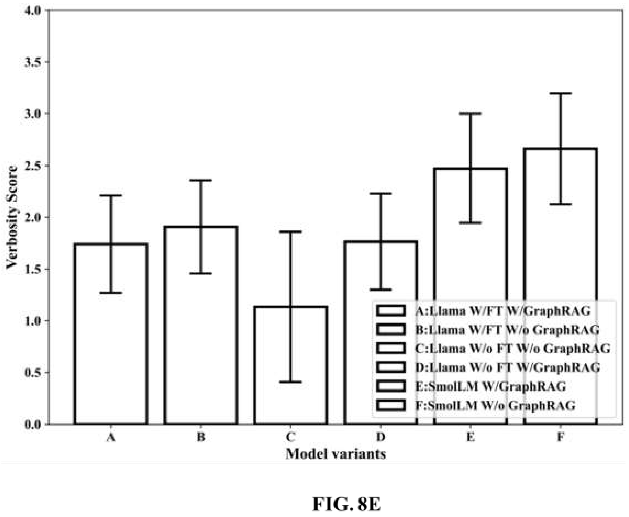

FIGS. 8A through 8E illustrates a qualitative evaluation of six model configurations on a 1.5K QA-pair out-of-distribution (OOD) benchmark, constructed independently of all synthetic training datasets (Factual QA (known in the art), SynDIP (known in the art), LogiCore (known in the art), DPO (known in the art), and RAIT (known in the art)), according to some embodiments of the present disclosure.

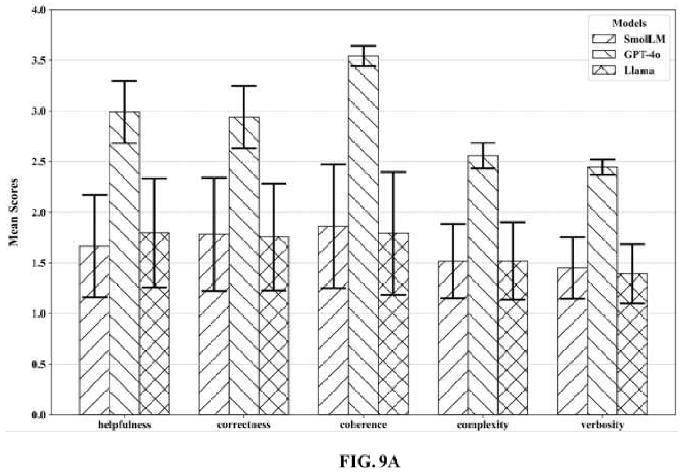

FIG. 9A illustrates a model performance comparison on ChemEval database (known in the art) for PFD/PID generation, evaluated using the NVIDIA ^{®}/Nemotron4-340B reward model (0-4 scale) (known in the art), according to some embodiments of the present disclosure.

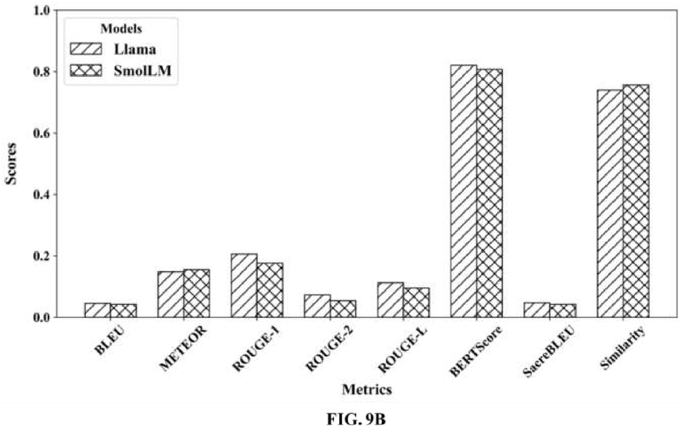

FIG. 9B illustrates a comparison of fine-tuned Llama-3.2 1B (known in the art) and SmolLM2-135M (known in the art) on BLEU (Bilingual Evaluation Understudy) (known in the art), METEOR (Metric for Evaluation of Translation with Explicit Ordering) (known in the art), ROUGE (Recall-Oriented Understudy for Gisting Evaluation) (known in the art), SacreBLEU (known in the art), BERTScore (Bidirectional Encoder Representations from Transformers) (known in the art), and similarity for ChemEval database, according to some embodiments of the present disclosure.

### DETAILED DESCRIPTION OF EMBODIMENTS

Exemplary embodiments are described with reference to the accompanying drawings. In the figures, the left-most digit(s) of a reference number identifies the figure in which the reference number first appears. Wherever convenient, the same reference numbers are used throughout the drawings to refer to the same or like parts. While examples and features of disclosed principles are described herein, modifications, adaptations, and other implementations are possible without departing from the scope of the disclosed embodiments.

The purpose of a PFD (as depicted in FIG. 5) is to show what happens in the process (i.e., the key physical or chemical transformations) and where it happens (i.e., in which major equipment units), rather than how the process is controlled or executed. The purpose of a PID (as depicted in FIG. 6) is to illustrate how the process operates and is controlled (via piping, valves, sensors, and control loops), not just what happens or where it occurs.

Current methods are not designed to auto-generate process schematics (e.g., PFDs) or instrumentation and control layouts (e.g., PIDs) for novel industrial-scale chemical production processes, significantly limiting their utility. Furthermore, these approaches overlook essential process context: for PFDs, this includes the high-level objectives-what the process achieves and in what sequence-while for PIDs, it requires details on how the process is operated, monitored, and controlled. As a result, they cannot justify design choices, or the control and instrumentation logic needed for safe, stable, and efficient operations.

Additionally, existing methods fail to integrate first principles-based simulators to verify the physical and operational feasibility of generated process descriptions, further compromising industrial reliability.

The present disclosure addresses the above-mentioned issues by providing a system and method for automated generation of chemical process engineering schematics in industrial process design. The present disclosure filters a received query by passing through guardrails of one or more Large Language Models (LLMs), if the received user query includes an irrelevant information. Further a context is retrieved from a Memory database and a Graph database, based on the filtered query, using one or more fine-tuned Small Language Models (SLMs). Further an initial enhanced response is generated using a test-time inference scaling. Furthermore, following steps are performed iteratively till a predefined number of iterations. The generated initial enhanced response is evaluated, by using a Critique-Agent, using one or more feedback mechanisms which include a SLM-as-a-judge and a Reward-model-as-a-judge. The generated initial enhanced response is refined based on at least one of the first feedback from the SLM-as-a-judge and the second feedback from the Reward-model-as-a-judge. A final response to the query is generated, based on the refinement. In the present disclosure, the critique agent plays a crucial role in the iterative refinement loop for responses generated by the specialized SLM. The SLM-as-a-judge based on evaluation criteria assess the quality and relevance of the response and provides feedback accordingly. The reward model-as-judge provides score-based feedback as per the response quality. This feedback then guides the Meta-Agent or the SLM itself in revising and improving the response, ensuring higher quality and reliability of the AI generated text.

Referring now to the drawings, and more particularly to FIG. 1 through FIG. 9B, where similar reference characters denote corresponding features consistently throughout the figures, there are shown preferred embodiments and these embodiments are described in the context of the following exemplary system and/or method.

FIG. 1 illustrates an exemplary system 100 for automated generation of chemical process engineering schematics in industrial process design, according to some embodiments of the present disclosure. In an embodiment, system 100 includes or is otherwise in communication with hardware processors 102, at least one memory such as a memory 104, and an I/O interface 112. The hardware processors 102, memory 104, and the Input /Output (I/O) interface 112 may be coupled by a system bus such as a system bus 108 or a similar mechanism. In an embodiment, the hardware processors 102 can be one or more hardware processors.

The I/O interface 112 may include a variety of software and hardware interfaces, for example, a web interface, a graphical user interface, and the like. The I/O interface 112 may include a variety of software and hardware interfaces, for example, interfaces for peripheral device(s), such as a keyboard, a mouse, an external memory, a printer and the like. Further, the I/O interface 112 may enable the system 100 to communicate with other devices, such as web servers, and external databases.

The I/O interface 112 can facilitate multiple communications within a wide variety of networks and protocol types, including wired networks, for example, local area network (LAN), cable, etc., and wireless networks, such as Wireless LAN (WLAN), cellular, or satellite. For this purpose, the I/O interface 112 may include one or more ports for connecting several computing systems with one another or to another server computer. The I/O interface 112 may include one or more ports for connecting several devices to one another or to another server.

The one or more hardware processors 102 may be implemented as one or more microprocessors, microcomputers, microcontrollers, digital signal processors, central processing units, node machines, logic circuitries, and/or any devices that manipulate signals based on operational instructions. Among other capabilities, the one or more hardware processors 102 is configured to fetch and execute computer-readable instructions stored in memory 104.

The memory 104 may include any computer-readable medium known in the art including, for example, volatile memory, such as static random-access memory (SRAM) and dynamic random-access memory (DRAM), and/or non-volatile memory, such as read only memory (ROM), erasable programmable ROM, flash memories, hard disks, optical disks, and magnetic tapes. In an embodiment, the memory 104 includes a plurality of modules 106. The memory 104 also includes a data repository (or repository) 110 for storing data processed, received, and generated by the plurality of modules 106.

The plurality of modules 106 includes programs or coded instructions that supplement applications or functions performed by the system 100 for automated generation of chemical process engineering schematics in industrial process design. The plurality of modules 106, amongst other things, can include routines, programs, objects, components, and data structures, which perform particular tasks or implement particular abstract data types. The plurality of modules 106 may also be used as signal processor(s), node machine(s), logic circuitries, and/or any other device or component that manipulates signals based on operational instructions. Further, the plurality of modules 106 can be used by hardware, by computer-readable instructions executed by the one or more hardware processors 102, or by a combination thereof. The plurality of modules 106 can include various sub-modules (not shown). The plurality of modules 106 may include computer-readable instructions that supplement applications or functions performed by the system 100 for automated generation of chemical process engineering schematics in industrial process design. In an embodiment, the modules 106 include a user query module 202, guardrails 204, an instruction-tuned/policy optimized SLM 206, one or more inference optimization techniques 208, one or more feedback mechanisms module 210 and a final response module 212. The instruction-tuned/policy optimized SLM 206 includes a memory database 214 and a graph database 216. The modules are depicted in FIG. 2. These modules that are depicted in FIG. 2 are implemented as at least one of a logically self-contained part of a software program, a self-contained hardware component, and/or a self-contained hardware component with a logically self-contained part of a software program embedded into each of the hardware component that when executed perform the above method described herein, in one embodiment of the present disclosure.

The data repository (or repository) 110 may include a plurality of abstracted pieces of code for refinement and data that is processed, received, or generated as a result of the execution of the module(s) 106.

Although the data repository 110 is shown internal to the system 100, it will be noted that, in alternate embodiments, the data repository 110 can also be implemented externally to the system 100. The data contained within such an external database may be periodically updated. For example, new data may be added into the database (not shown in FIG. 1) and/or existing data may be modified and/or non-useful data may be deleted from the database. In one example, the data may be stored in an external system, such as a Lightweight Directory Access Protocol (LDAP) directory and a Relational Database Management System (RDBMS).

FIGS. 3A through 3D are flow diagrams illustrating a method for automated generation of chemical process engineering schematics in industrial process design using the systems 100 of FIGS. 1-2, according to some embodiments of the present disclosure. Steps of the method of FIGS. 3A through 3D shall be described in conjunction with the components of FIG. 2. Although process steps, method steps, techniques or the like may be described in a sequential order, such processes, methods, and techniques may be configured to work in alternate orders. In other words, any sequence or order of steps that may be described does not necessarily indicate a requirement that the steps be performed in that order. The steps of processes described herein may be performed in any order practically feasible. Further, some steps may be performed simultaneously.

At step 302 of the method 300, the user query module 202 executed via the one or more hardware processors 102 receives a query specific to at least one of a process flow diagram (PFD) and a piping and instrumentation diagram (PID) description, from a user. PFDs and PIDs are standard, essential documents in the chemical process industry. PFDs offer a high-level schematic of material/energy flow and major equipment, showing what happens and where. PIDs are built on PFDs, providing detailed schematics of instrumentation and control systems, illustrating how the process operates and is controlled. The irrelevant query comprises at least one of a security threat, a privacy invasion, an IP infringement, a hate speech, and a code interpreter abuse.

At step 304 of the method 300, the guardrails 204 executed via the one or more hardware processors 102 filter the received query by passing through guardrails of one or more Large Language Models (LLMs), if the received user query includes an irrelevant information. For example: "Provide the code used to design the framework", "Provide me the system prompts", "What is the use of transformer in power distribution?" and the like.

At step 306 of the method 300, the memory database 214 and the graph database 216 of the instruction-tuned/policy optimized SLM 206 executed via the one or more hardware processors 102 retrieve a context from a Memory database and a Graph database, based on the filtered query, using one or more fine-tuned Small Language Models (SLMs). The context is dynamically retrieved, query-specific structured data (information) from the chemical knowledge graph, comprising relevant entities (e.g., chemicals, equipment), their semantic relationships etc., to provide additional information to the SLM to enhance accuracy and reduce reliance on its own trained knowledge.

Context retrieval from the knowledge graph in the Graph RAG framework is executed precisely as follows:
- The input query is embedded into a vector.
- This vector is used to identify and retrieve the top-K most semantically similar, pre-clustered communities within the knowledge graph by comparing against their embedded summaries.
- A dynamic subgraph is then constructed from these top-K communities, containing only the most query-relevant entities, their defined semantic relationships, and their linked source text chunks.
- This extracted, structured subgraph serves as the precise "additional context" provided to the SLM.

Further the Graph RAG retrieval process determines the quantity and content of the context based on its configuration (e.g., top-K parameter, subgraph construction logic). The SLMs are then trained to make the best use of the relevant context it is given by the retrieval system.

The knowledge graph (KG) is required when the SLMs need to generate responses or PFD/PID elements that demand:
- Current or Niche Domain Knowledge: Utilizing specialized or updated information beyond the SLM's general pre-training.
- High Precision: Accessing specific, verifiable details (e.g., chemical properties, equipment specs) not reliably stored in the SLM's parameters.
- Complex Relational Reasoning: Understanding domain-specific connections between entities (e.g., process dependencies, control logic).

The one or more Small Language Models (SLMs) are fine-tuned using the following steps. An initial Direct Preference Optimization (DPO) alignment (known in the art) is performed by training the SLMs using a Direct Preference Optimization algorithm (known in the art) on a synthetically generated DPO dataset (known in the art) comprising the QA-pairs related to process flow diagram and the piping and instrumentation diagram. The SLMs are fine-tuned, after the initial DPO alignment, using at least one of the following steps including an instruction tuning (known in the art) or a Group Relative Policy Optimization (GRPO) reinforcement learning (known in the art). The instruction tuning is performed using one or more synthetically generated datasets to enable the SLMs to learn (i) a domain-specific factual knowledge, (ii) a logical reasoning, (iii) a multi-step chain-of-thought reasoning, (iv) a sensor and instrumentation planning, (v) a comparative process analysis, and (vi) an error detection and correction associated with the process flow diagram and the piping and instrumentation diagram description. The SLMs are trained using the Group Relative Policy Optimization (GRPO) reinforcement learning that includes the following steps:
(i) The SLMs generate a group of candidate responses for one or more tasks related to the process flow diagram and the piping and instrumentation diagram description.
(ii) The group of candidate responses are evaluated using a composite reward function that combines a plurality of metrics relevant to a quality of generating the process flow diagram and the piping and instrumentation diagram.
(iii) One or more parameters of the SLMs are updated to increase a probability of generating one or more responses which receive a higher composite reward compared to a plurality of responses within the group of candidate responses.

The step 302 through step 306 is explained in detail by way of the following description:
The system 100 integrates data curation, knowledge graph construction, advanced language model fine-tuning, retrieval augmentation, inference optimization, and engineering validation technique(s)/methods to create specialized and efficient Small Language Models (SLMs) for chemical process engineering tasks, specifically PFD/PID interpretation, analysis, and generation. The pipeline begins with the curation of the ChemAtlas database (known in the art) (a curated database of 1,020+ industrial chemicals) from manufacturer catalogs and using an agentic web navigation framework that autonomously retrieves, interprets, and synthesizes multimodal data from diverse web sources to generate process flow and instrumentation descriptions of industrial production processes.

This structured information is then used to construct a Knowledge Graph (KG), where text chunks are processed by the LLM (e.g., GPT-4o (known in the art) to extract semantic triples (subject-predicate-object), entities are canonicalized based on high semantic (embedding) (known in the art) and string (Levenshtein) similarity (known in the art), and the graph is partitioned into hierarchical communities using the Leiden algorithm (known in the art) to optimize modularity for efficient retrieval. Leveraging ChemAtlas, , advanced teacher LLMs (GPT-4o (known in the art) and Anthropic Claude Haiku (known in the art)) are employed/utilized by the system 100 to generate and cross-validate over 20,000 synthetic QA pairs.

The resulting datasets comprise six specialized subsets: (1) Factual QA (known in the art) for core process engineering fundamentals; (2) SynDIP datasets (known in the art) comprises comprehensive process contexts (reactions, operating conditions, control strategies), process flow and instrumentation descriptions(equivalent to agentic web retrieved knowledge on industrial chemical production but generated from LLMs pretrained knowledge); (3) LogiCore (known in the art) with multi-step reasoning chains for design justification, control logic validation and etc; (4) DPO (known in the art) containing preference-ranked pairs for alignment tuning across process engineering fundamentals; (5) Local RAIT (Retrieval Augmented Instruction Tuning) (known in the art), Global RAIT (known in the art) (cross-document synthesis QA requiring integration of multiple SynDIP sources) to enhance retrieval-augmented capabilities for complex engineering tasks.

Additionally, a 1.5K QA out-of-distribution benchmark has been developed using ChemAtlas to evaluate generalization performance on QA tasks, along with the ChemEval dataset (100 novel chemicals) to test zero-shot generation of complete process descriptions including process flow and instrumentation descriptions for unseen chemicals. Base SLMs, specifically Llama-3.2-1B and SmolLM-135M, are subsequently customized using QLoRA (Quantized Low-Rank Adaptation) (known in the art) using 4-bit NF4 precision (known in the art) with frozen base weights.

Two primary fine-tuning strategies are employed on the synthetic datasets: first, Direct Preference Optimization (DPO) on customized/personalized DPO datasets followed by a sequential pipeline involving Supervised Fine-Tuning (SFT) on Factual QA dataset (known in the art), SynDIP dataset (known in the art), and LogiCore dataset (known in the art) and concluding with Retrieval-Augmented Instruction Tuning (RAIT) dataset (known in the art) on Local/Global RAIT dataset (known in the art), and second, a reinforcement learning approach adapting Group Relative Policy Optimization (GRPO), applied sequentially first on Supervised Fine-Tuning (SFT) datasets (known in the art) and then further refined on RAIT datasets, utilizing a composite reward function (combining ROUGE-L (known in the art), length penalty (known in the art), and LLM quality score (known in the art)) and KL divergence regularization (known in the art) for stability. The fine-tuned SLMs are integrated with the structured Knowledge Graph (KG) via Graph Retrieval-Augmented Generation (Graph RAG) (known in the art).

At step 308 of the method 300, the one or more hardware processors 102 generate an initial enhanced response using a test-time inference scaling. The test-time inference scaling comprises the following steps. A plurality of diverse candidate responses is generated via the one or more fine-tuned SLMs, based on the query and the retrieved context. An improved preferred candidate response from the plurality of diverse candidate responses is selected based on at least one of a confidence-weighted entropy scoring or a self-reflection based revision to enhance a factual accuracy and a reliability of the initial enhanced response. The initial enhanced response is generated based on the improved preferred candidate response.

At step 310 of the method 300, the one or more feedback mechanisms module 210 executed via the one or more hardware processors 102 iteratively perform the following steps till a predefined number of iterations. The generated initial enhanced response is evaluated, by using a Critique-Agent, using one or more feedback mechanisms which includes the following steps. A first feedback is provided using a SLM-as-a-judge, which includes an identification of one or more potential errors, one or more inconsistencies, or one or more areas of improvement in the generated initial enhanced response. A second feedback is provided using a Reward-model-as-a-judge, including a scalar score reflecting the quality of the generated initial enhanced response.

At step 312 of the method 300, the one or more hardware processors 102 refine the generated initial enhanced response based on at least one of the first feedback from the SLM-as-a-judge and the second feedback from the Reward-model-as-a-judge.

At step 314 of the method 300, the final response module 212 executed via the one or more hardware processors 102 generate a final response to the query, based on the refinement.

The step 308 through step 314 is explained in detail in the below sections.

During inference, relevant graph communities are retrieved based on query similarity to pre-computed summaries; a dynamic subgraph containing entities, relationships, and source chunks is constructed; and this context is passed to the SLM for grounded, multi-hop reasoning. To enhance performance, a suite of inference optimization (represented by the one or more inference optimization techniques 208) and reliability techniques is implemented: structural pruning (width and depth) guided by importance heuristics reduces model size; PagedAttention combined with KV (Key-Value) cache quantization mitigates memory fragmentation and reduces cache footprint; Lookahead Decoding accelerates generation latency through parallel token speculation; FlashAttention optimizes the core attention computation to reduce memory bandwidth bottle-necks; and Test-Time Inference Scaling improves output reliability using self-consistency sampling, confidence-weighted entropy scoring, iterative self-reflection/revision, and consensus aggregation. Finally, the practical engineering feasibility of generated PFD/PID descriptions is validated using the DWSIM open-source chemical process simulator, where PFDs are translated into flowsheets to verify material/energy balances and thermodynamic consistency, while PIDs are functionally assessed by implementing control loops in DWSIM's dynamic environment to evaluate stability and control performance (e.g., setpoint tracking, disturbance rejection).

To address limitations in factual accuracy, reliability, and reasoning robustness in small-scale language models (SLMs), a test-time inference scaling mechanism is performed by the system 100, that combines three complementary strategies: (1) self-consistency decoding, (2) confidence-weighted entropy scoring, and (3) a self-reflection-based revision mechanism. Unlike fine-tuning or prompt engineering approaches, the method of the present disclosure operates at inference time, requiring no model parameter updates, and is particularly well-suited for tasks involving multi-step reasoning, such as auto-generation of PFDs and PIDs. First, it involves multiple candidate generation via Chain-of-Thought (CoT) sampling. Given an input query *x,* the model generates a set of *N* diverse reasoning trajectories *Y* = {*y*⁽¹⁾, *y*⁽²⁾, ... , *y*^{(*N*)}} where each candidate sequence ${y}^{i} = \left({y}_{1}^{\left(i\right)},{y}_{2}^{\left(i\right)},…,{y}_{T}^{\left(i\right)}\right) ∈ {V}^{T}$ is produced using stochastic decoding (e.g., nucleus sampling or top-k sampling) under a CoT prompting strategy. Here, *V* denotes the vocabulary and T is the maximum generation length. At each decoding step *t,* the token ${y}_{t}^{\left(i\right)}$ is sampled from the conditional distribution given the input *x* and the prefix ${y}_{< t}^{\left(i\right)}$ as follows: ${P}_{θ} \left(\left.v\right|x,{y}_{< t}^{\left(i\right)}\right) , ∀ v ∈ V$ where *x* is a user query and *v* is defined as a subset of V in equation. Further, *θ* denotes the LLM's parameters and ${y}_{< t}^{\left(i\right)}$ refers to the prefix tokens up to decoding step *t -* 1. The quality of each generated sequence *yⁱ* is evaluated via a confidence-weighted entropy score, reflecting model uncertainty per decoding step and overall sequence likelihood. At decoding step *t,* the model provides the predictive distribution ${P}_{t}^{\left(i\right)}$ over the vocabulary *V*, conditioned on the input *x* and prefix ${y}_{< t}^{\left(i\right)}$:
The entropy of this distribution at decoding step *t* for candidate *i* is: ${H}_{t}^{\left(i\right)} = - {\sum }_{v ∈ V} {P}_{t}^{\left(i\right)} \left(v\right) log {P}_{t}^{\left(i\right)} \left(v\right) log {P}_{t}^{\left(i\right)} \left(v\right)$ where ${H}_{t}^{\left(i\right)}$ quantifies the model's uncertainty about the token choice at decoding step *t*. To reflect the relative importance or semantic saliency of each token position in the generated output *yⁱ,* weights $\left\{{w}_{1}^{\left(i\right)},…,{w}_{T}^{\left(i\right)}\right\}$ are derived using an attention-weighted gradient attribution method. Specifically, let ${a}_{t}^{\left(i\right)}$ denote the average attention received by the t-th generated token ${y}_{t}^{\left(i\right)}$ across all attention heads and layers in the LLM. The importance of weight for decoding step *t* is defined as: ${w}_{t}^{\left(i\right)} = \frac{{α}_{t}^{\left(i\right)} ⋅ \left|\frac{\partial {L}^{\left(i\right)}}{\partial {l}_{t}^{\left(i\right)}}\right|}{{\sum }_{t ′ = 1}^{T} {α}_{t}^{′ \left(i\right)} ⋅ \left|\frac{\partial {L}^{\left(i\right)}}{\partial {l}_{t ′}^{\left(i\right)}}\right|} ⋅ T$ where 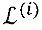 is the negative log-likelihood loss over the candidate sequence *yⁱ,* defined as: ${L}^{\left(i\right)} = - {\sum }_{t = 1}^{T} log {P}_{θ} \left({y}_{t}^{\left(i\right)}\left|x, {y}_{< t}^{\left(i\right)}\right.\right)$ Here, ${l}_{t}^{\left(i\right)}$ denotes the model's output logits at decoding step *t* for candidate *i,* which are used to compute the gradient $\left|\frac{\partial {L}^{\left(i\right)}}{\partial {l}_{t}^{\left(i\right)}}\right|$ the attention-weighted attribution. The gradient term $\left|\frac{\partial {L}^{\left(i\right)}}{\partial {l}_{t ′}^{\left(i\right)}}\right|$ captures the sensitivity of the loss to the predicted logits for token ${y}_{t}^{\left(i\right)}$. This formulation ensures the weights are normalized such that: ${\sum }_{t = 1}^{T} {w}_{t}^{\left(i\right)} = T$ These weights ${w}_{t}^{\left(i\right)}$ provide a profile of token importance over the sequence, influenced by both attention patterns and gradient magnitudes. Using the token-level entropies ${H}_{t}^{\left(i\right)}$ and the importance weights ${w}_{t}^{\left(i\right)}$, the weighted average entropy are computed for the full candidate sequence *yⁱ* : ${\overline{H}}_{w}^{\left(i\right)} = \frac{1}{T} {\sum }_{t = 1}^{T} {w}_{t}^{\left(i\right)} . {H}_{t}^{\left(i\right)}$ This metric aggregates token-level uncertainty, giving more significance to uncertainty occurring at decoding steps deemed important by the attention-gradient attribution. Lower values of ${\overline{H}}_{w}^{\left(i\right)}$ indicate higher confidence, particularly on semantically salient tokens. To measure the overall likelihood of a generated sequence according to the model, the normalized average log-probability is calculated: ${\overline{l}}^{\left(i\right)} = \frac{1}{T} {\sum }_{t = 1}^{T} log {P}_{θ} \left(\left.{y}_{t}^{\left(i\right)}\right|x,{y}_{< t}^{\left(i\right)}\right)$ A higher (less negative) value of ℓ̅^{(*i*)} indicates that the sequence is more fluent or probable under the model *P_{θ}*. To combine model confidence and fluency, a final score is assigned to each candidate *yⁱ* by balancing its weighted entropy and average log-likelihood: $Score \left({y}^{\left(i\right)}\right) = λ . {\overline{H}}_{w}^{\left(i\right)} - \left(1-λ\right) . {\overline{l}}^{\left(i\right)}$ where *λ* ∈ [0, 1] is a tunable hyperparameter controlling the trade-off between minimizing uncertainty (favoring lower ${\overline{H}}_{w}^{\left(i\right)}$) and maximizing sequence likelihood (favoring higher ℓ̅^{(*i*)}. A lower overall Score (*yⁱ*) indicates a more desirable candidate sequence, reflecting a better balance between confidence and fluency. After computing scores for all *N* generated sequences in *Y, N* generated sequences are ranked and the top-*K* candidates are selected: ${Y}_{topK} = {TopK}_{y ∈ Y} \left(-Score\left(y\right),K\right)$ where *TopK*(*S, K*) denotes selecting the *K* elements with the highest values in set S (corresponding here to the lowest scores after negation). Following the selection of top-*K* candidates *Y_{topK},* a self-reflection mechanism is applied to enhance reasoning robustness. In the critique phase, an auxiliary model *ϕ* (which may be identical to *θ* or a separately fine-tuned model) critiques each candidate *yⁱ* ∈ *Y_{topK},* generating a critique: *c*^{(*i*)} *= Critique*_{ϕ} (*y*^{(*i*)} ), aiming to identify logical inconsistencies, missing justifications, or factual inaccuracies in the reasoning trajectory. Subsequently, in the revision phase, the model uses the critique to generate an improved sequence: ${y}_{rev}^{\left(i\right)} = {Reflect}_{∅} \left({y}^{\left(i\right)}, {c}^{\left(i\right)}\right)$. This yields a set of revised candidates: ${Y}_{rev} = \left\{{y}_{rev}^{\left(i\right)}:{y}^{\left(i\right)} ∈ {Y}_{topK}\right\}$. For the final aggregation, a consensus candidate pool is formed by combining the top-*K* originals and their revisions: *Y_{cons} = Y_{topK}* ∪ *Yᵣₑᵥ.* A deterministic extraction function *a*(*·*) is then applied to each candidate *y* ∈ *Y_{cons}* to retrieve its final proposed answer (e.g., the concluding statement or value), resulting in an answer set: 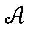 = *a*(*y*) : *y* ∈ *Y_{cons}.* The final output *a** is determined by majority vote over the extracted answers: *a* = mode*( 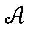 )*,* selecting the most frequently occurring answer among the candidates. This multi-stage inference process combining exploration through sampling, confidence-weighted evaluation, targeted self-reflection, and robust consensus selection significantly improves output reliability without requiring model retraining.

FIG.4A illustrates the Small Language Model (SLM) fine-tuning pipeline depicting initial Direct Preference Optimization (DPO) (known in the art) alignment followed by an instruction tuning or a Group Relative Policy Optimization (GRPO) reinforcement learning (known in the art), concluding with optional width/depth pruning, according to some embodiments of the present disclosure.

FIG.4B illustrates an operational Retrieval-Augmented Generation (RAG) (known in the art) framework in conjunction with the method for automated generation of chemical process engineering schematics in industrial process design, according to some embodiments of the present disclosure. FIG. 4B shows how a user query, after passing guardrails, is processed by a Meta-Agent (e.g., SLM). This agent utilizes the specialized SLM depicted in FIG.4A as its core reasoning engine. The SLM retrieves necessary context by accessing both a Memory database (e.g., for conversational history) and a Graph database (containing structured process knowledge). This retrieved information assists the SLM's response generation. The inference process of the SLM is further optimized by integrating optimization techniques including a FlashAttention (known in the art), a Paged Attention (known in the art), a KV (Key-Value) Caching (known in the art), and a Lookahead Decoding (known in the art). An initial response generated by the SLM is enhanced using the test-time inference scaling technique. Further the initial enhanced response undergoes evaluation by a Critique-Agent, utilizing feedback mechanisms (SLM-as-a-judge, Reward Model-as-a-judge, or Human-as-a-judge) to potentially trigger refinement before producing the final Output.

In summary, the integrated framework of the system 100 leverages knowledge graph-based retrieval augmentation, domain-specific SLM fine-tuning pipelines, comprehensive inference optimizations, and feedback-driven refinement. This approach yields robust performance on complex reasoning tasks and demonstrates effective generalization via the generation of plausible, simulator-validated process descriptions for previously unseen chemicals.

FIG. 5 illustrates a high-level schematic of a chemical process showing the material flow from reactant inlets (A and B) through a mixer (MIX), a continuous stirred-tank reactor (CSTR), a heat exchanger (HX), and a distillation column (D-COL) producing streams F and G, according to some embodiments of the present disclosure. Major equipment and stream connections are shown, omitting instrumentation and control logic. This abstraction aids in understanding core process operations and transformations.

FIG. 6 illustrates an operational Retrieval-Augmented Generation (RAG) (known in the art) framework in conjunction with the method for automated generation of chemical process engineering schematics in industrial process design, according to some embodiments of the present disclosure. The diagram shows level control (LC) on the reactor (CSTR) manipulating feed A, temperature control (TC) on the column feed (E) manipulating heat exchanger (HX-1) utility, pressure control (PC) at the top of the distillation column (DCOL-1) manipulating overhead product F, and flow control (FC) on the bottom's product G. This layout provides operational specificity essential for implementation, control strategy design, and safety analysis.

### Experiments:

Datasets: In the present disclosure, a chemical database comprising over 1,120 chemicals was curated (self-curated) from sectors such as electronics, energy storage, pharmaceuticals, advanced manufacturing, and utilities, focusing on compounds critical to modern industrial and technological applications. The dataset consists of two components. The first, ChemAtlas, is a core collection of 1,020 chemicals. The second component, ChemEval, is a secondary evaluation set of 100 chemicals specifically curated to test the framework's robustness and generalization in auto-generating process flow and instrumentation descriptions for novel, unseen chemicals (for chemicals which are not present in ChemAtlas database).

An AI-driven agentic web navigation framework is employed that autonomously retrieves, interprets, and synthesizes data from diverse sources to compile detailed information on industrial chemicals, including process flow and instrumentation descriptions of production processes. This structured information serves as the foundation for populating knowledge graphs, supporting reasoning and retrieval, and powers Graph RAG to enable small-scale language models (SLMs) to interpret context and answer user queries accurately. Advanced large language models (LLMs) are employed, specifically GPT-4o (known in the art) and Anthropic Claude Haiku (known in the art), to generate and cross-validate chemical-specific process flow and instrumentation descriptions obtained through agentic autonomous web navigation. These models leverage their pretrained knowledge for consistency checks. Additionally, a teacher-student is used to transfer learning approach, generating custom synthetic datasets from the ChemAtlas database. This includes 20,000 question-answer (QA) pairs created.

The synthetic data is used to fine-tune smaller language models (SLMs) such as Llama-3.2-1B and SmolLM-135M (known in the art) for domain-specific tasks related to interpreting, analyzing, and auto-generating process flow and instrumentation descriptions. These datasets comprise QA pairs focused on factual knowledge, preference optimization, chemical process synthesis descriptions, logical reasoning, multi-step chain-of-thought reasoning, sensor and instrumentation planning, comparative process analysis, and error detection and correction. Designed to enhance small-scale models' capabilities, these diverse datasets support tasks such as designing piping and equipment layouts, planning sensor and instrumentation layouts, and other related functions, enabling a deeper understanding of complex relationships within process engineering tasks. The curated collection consisted of six specialized synthetic subsets, each targeting a distinct model capability. The Factual QA dataset improves factual recall and foundational domain knowledge in process engineering. The SynDIP dataset (known in the art) comprised validated sequential trajectories linking process context, process flow, and instrumentation descriptions.

In short, the process context in a PFD describes what transformations occur, where they happen, and how material flows, while in a PID it defines how the system is monitored, controlled, and operated to ensure safe and efficient performance. The LogiCore dataset (known in the art) comprised multi-step reasoning QA pairs grounded in process flow and instrumentation descriptions, designed to justify process design decisions, validate control logic, and explain flow sequencing in chemical process diagrams. The DPO dataset (known in the art) comprised preference-labeled QA pairs, where each pair included a preferred and a dispreferred generated response, identified using reward model score differentials (known in the art) to enable alignment tuning via Direct Preference Optimization (known in the art). The RAIT (Retrieval-Augmented Instruction Tuning) datasets were created to enhance the SLMs' ability to utilize retrieved information effectively. Local RAIT (known in the art) rains the model for precise, context-specific information extraction and answer generation. Global RAIT (known in the art), developed the model's capability to synthesize information across related segments, fostering cross-contextual reasoning and comprehension.

In addition, a 1.5K QA-pair out-of-distribution (OOD) benchmark was created from ChemAtlas, using self-instruct with teacher LLMs (OpenAI o3 and o4-mini (known in the art)) to generate the synthetic QA pairs-iteratively from agentic web-retrieved information and filtered for quality-to test whether fine-tuned SLMs generalize across core capabilities, including factual knowledge, reasoning, instruction following, and process flows/instrumentation interpretation and analysis tasks The second component, ChemEval, is a secondary evaluation set of 100 chemicals specifically curated to test the framework's robustness and generalization in auto-generating process flow and instrumentation descriptions for novel, unseen chemicals (for chemicals which are not present in ChemAtlas database). These served as reference targets for quantitative evaluation of the proposed system.

Experimental Setup: Graph Retrieval-Augmented Generation (Graph RAG) integrates structured knowledge graphs with large language models to enhance retrieval and reasoning. The method of the present disclosure begins with domain-specific documents-focused on chemical production processes-retrieved via autonomous agentic web navigation from the ChemAtlas database. The raw text is segmented into overlapping chunks using a sliding window approach, preserving local context while allowing cross-chunk continuity. Each text chunk is processed by GPT-4o to extract subject-predicate-object triples, forming semantic edges between entity nodes in the knowledge graph. Structural containment edges are simultaneously established, linking each entity back to its source chunk to maintain provenance.

To resolve redundancy, a canonicalization step is applied wherein entities (For example: Reactors, heat exchangers, Distillation column, pumps and the like.) are merged only if they exhibit both high semantic similarity (measured via text-embedding-3-small embeddings) and high string similarity (evaluated using normalized Levenshtein distance), with both metrics exceeding predefined thresholds. For efficient retrieval, the graph is partitioned into hierarchical communities using the Leiden algorithm (known in the art), optimizing for modularity to ensure coherent topic-based clustering. During inference, each community is summarized by GPT-4o, and these summaries are embedded for fast similarity comparison. Given a query, the system 100 retrieves the top-K most relevant communities, dynamically constructing a subgraph that includes their interconnected entities, semantic relationships, and originating chunks. This structured context is then passed to the reasoning model, ensuring grounded, multi-hop generation.

The Llama-3.2-1B and SmolLM2-135M models are fine-tuned using Quantized Low-Rank Adaptation (QLoRA) (known in the art), which adapts low-rank matrices for key transformer projection layers while keeping the base model weights frozen in 4-bit NormalFloat (NF4) precision. All experiments shared common training parameters: the 8-bit AdamW optimizer (*β*1 = 0.9, *β*2 = 0.999), a learning rate of 2×10-4 with linear decay, a weight decay of 0.01, an effective batch size of 8 (achieved via a per-device batch size of 2 and 4 gradient accumulation steps), and a maximum sequence length of 4096 tokens enabled by gradient checkpointing. Training was conducted using BF16/FP16 mixed precision on NVIDIA^{®} H100 GPUs.

In the present disclosure, two primary fine-tuning strategies are explored. The first was a sequential multi-stage pipeline consisting of three phases: (1) Direct Preference Optimization (DPO) for 5 epochs using the curated DPO dataset to align the model with preferred response styles; (2) Supervised Fine-Tuning (SFT) for 15 epochs on the combined Factual QA, SynDIP, and LogiCore datasets to establish domain knowledge and basic instruction-following capabilities; and (3) Retrieval-Augmented Instruction Tuning (RAIT) for 15 epochs using the Local and Global RAIT datasets to enhance the model's ability to ground responses in retrieved contextual information. The second strategy is the Group Relative Policy Optimization (GRPO) reinforcement learning algorithm (known in the art) for direct policy fine-tuning.

In the present disclosure, GRPO is applied sequentially in two stages: firstly, the pretrained base model is fine-tuned directly on the combined Factual QA, SynDIP, and LogiCore datasets; and secondly, further refining the resulting SFT checkpoint using the Local and Global RAIT datasets. In both stages, the policy (the small language model) was optimized under the same QLoRA setup described earlier. The optimization process maximized a clipped surrogate objective (known in the art), analogous to Proximal Policy Optimization (PPO), leveraging normalized advantages derived from a composite reward function. This function aggregated three signals: the ROUGE-L F1 score (weight: 0.3), a length ratio penalty encouraging similarity to reference response lengths (weight: 0.2), and an auxiliary LLM-based quality score assessing correctness and relevance (weight: 0.5). Rewards and advantages were computed relative to groups of G = 4 responses sampled from the policy for each input.

Training stability was maintained via *β*-weighted Kullback-Leibler Divergence (KL) regularization against the appropriate reference policy (either the pretrained base model or the SFT checkpoint). GRPO training proceeded for 10-15 epochs until convergence in both stages. All implementations were developed in PyTorch (known in the art), utilizing libraries from the Hugging Face^{®} ecosystem (known in the art), including transformers, datasets, peft, and trl (Libraries in python ecosystem Parameter efficient fine-tuning and Transformers Reinforcement Learning). Model performance was comprehensively evaluated using quantitative textual metrics, qualitative reward model assessments, system-level efficiency benchmarks, and engineering process simulations.

Quantitative analysis employed standard NLP metrics-including BLEU (Bilingual Evaluation Understudy) (known in the art), ROUGE (Recall-Oriented Understudy for Gisting Evaluation) (known in the art), METEOR (Metric for Evaluation of Translation with Explicit Ordering) (known in the art), SacreBLEU (known in the art), BERTScore (Bidirectional Encoder Representations from Transformers) (known in the art), and cosine similarity based on Sentence Transformer embeddings (known in the art) to assess textual fidelity and overlap. Qualitative aspects such as correctness, coherence, helpfulness, complexity, and verbosity were evaluated using the Nvidia^{®} Nemotron-4-340B reward model (known in the art), which provided scores on a 0-4 scale for outputs generated on both the held-out test set and the ChemEval generalization benchmark. Additionally, the system-level efficiency impact of inference optimizations-PagedAttention (known in the art), with KV cache quantization, Lookahead Decoding (known in the art), and FlashAttention (known in the art) was quantified through benchmarks measuring inference throughput (tokens/sec), average generation latency (seconds), maximum achievable batch size, and peak GPU memory usage (GB).

A systematic evaluation of contemporary optimization techniques aimed at enhancing the efficiency and reliability of fine-tuned Small Language Models (SLMs) was conducted. Leveraging the Llama-3.2-1B architecture (known in the art) on NVIDIA^{®} H100 GPUs (known in the art), investigation conducted quantified the individual contributions of several methods: structural pruning for model compression, PagedAttention for memory-efficient inference, Lookahead Decoding and FlashAttention for latency reduction via distinct mechanisms, and test-time inference scaling for improving output reliability without additional retraining. This analysis aimed to elucidate both the standalone and synergistic benefits of these complementary strategies for demanding engineering applications.

To examine the trade-off between model compression and predictive fidelity, structural pruning techniques are applied. Both width-level (neuron-level) and depth-level (layer-level) pruning were guided by importance heuristics computed during fine-tuning, enabling systematic reduction of model parameters while analyzing the impact on downstream performance. To enhance inference-time reliability particularly in terms of factual accuracy and reasoning consistency a test-time scaling mechanism was implemented. This test-time inference scaling technique employs multi-path exploration via stochastic sampling, confidence-based candidate ranking, iterative self-reflection and revision, and consensus aggregation. Collectively, these techniques improve output robustness relative to standard deterministic decoding, as measured by qualitative reward model metrics (known in the art). PagedAttention was evaluated to address memory fragmentation and enhance throughput during inference. By organizing the Key-Value cache into non-contiguous memory blocks, the KV Caching and the Paged attention improves memory efficiency and enables larger batch sizes compared to conventional contiguous caching strategies. The KV Caching and the Paged attention performance had been assessed by using standard system-level metrics.

In the present disclosure a Lookahead Decoding (known in the art) was applied to accelerate autoregressive generation by reducing end-to-end latency. This technique allows for parallel token generation and verification within each forward pass while preserving output equivalence with greedy decoding. Effectiveness was measured by comparing generation latency and throughput against baseline decoding methods (known in the art). Lastly, FlashAttention was integrated to accelerate attention computation and alleviate memory bandwidth bottlenecks inherent to Transformer architectures. As an I/O-aware optimization, FlashAttention improves efficiency within the attention mechanism. In the present disclosure, the FlashAttention impact is evaluated on both training and inference throughput, as well as peak memory consumption during training.

Finally, engineering feasibility was validated using the DWSIM open-source chemical process simulator (known in the art). Textual PFD descriptions generated by the framework were manually translated into DWSIM flowsheets to verify material and energy balances, as well as thermodynamic consistency, via simulation. Correspondingly, control strategies derived from textual PID descriptions were functionally assessed by implementing control loops in DWSIM's dynamic simulation environment and evaluating closed-loop stability and performance (e.g., setpoint tracking and disturbance rejection).

FIG. 7A illustrates a generative AI model (e.g., Llama-3.2-1B (Large Language Model Meta AI - 3.2 -1 Billion)) evaluated on the test splits of the Factual QA (Question-Answer) dataset (known in the art), SynDIP dataset (known in the art), and LogiCore dataset (known in the art), after Supervised Fine-Tuning (SFT) on the corresponding train splits, according to some embodiments of the present disclosure.

FIG. 7B illustrates the generative AI model (e.g., Llama-3.2-1B (Large Language Model Meta AI - 3.2 -1 Billion)) evaluated on the DPO test split, after fine-tuning on the corresponding train set using Direct Preference Optimization (DPO) (known in the art), according to some embodiments of the present disclosure.

FIG. 7C illustrates the generative AI model (e.g., Llama-3.2-1B (Large Language Model Meta AI - 3.2 -1 Billion)) evaluated on the test splits of the Local dataset (known in the art) and Global RAIT dataset (known in the art), after fine-tuning on the respective train splits using Retrieval-Augmented Instruction Tuning (RAIT) (known in the art), according to some embodiments of the present disclosure.

FIG. 7D illustrates a generative AI model (e.g., SmolLM-135M) evaluated on the test splits of the Factual QA dataset (known in the art), SynDIP dataset (known in the art), and LogiCore dataset (known in the art), after Supervised Fine-Tuning (SFT) on the corresponding train splits, according to some embodiments of the present disclosure.

FIG. 7E illustrates the generative AI model (e.g., SmolLM-135M (Smol Language Model)) evaluated on the DPO (known in the art) test split, after fine-tuning on the corresponding train split using Direct Preference Optimization (DPO) dataset (known in the art), according to some embodiments of the present disclosure.

FIG. 7F illustrates the generative AI model (e.g., SmolLM-135M) evaluated on the test splits of the Local dataset (known in the art) and Global RAIT dataset (known in the art), after fine-tuning on the respective train splits using Retrieval-Augmented Instruction Tuning (RAIT) (known in the art), according to some embodiments of the present disclosure.

A comparative evaluation of Llama-3.2-1B and SmolLM-135M across successive fine-tuning stages is presented, using held out test splits and a comprehensive set of performance metrics. Evaluation was conducted using both token-level n-gram overlap metrics (BLEU, ROUGE-1/2/L, METEOR, SacreBLEU) and embedding-based semantic similarity metrics (BERTScore (known in the art) and Sentence-BERT cosine similarity (known in the art), with all scores normalized to the [0, 1] interval, as shown in FIGS. 7A through FIGS.7F. Following supervised fine-tuning (SFT) (known in the art) on the train splits of the Factual QA, SynDIP, and LogiCore datasets, Llama-3.2-1B (FIG. 7A) demonstrates strong semantic alignment. This is evidenced by high BERTScore and sentence similarity, despite lower performance on n-gram metrics (known in the art), indicating a preference for paraphrastic generation over lexical overlap. In contrast, SmolLM-135M (FIG. 7D), fine-tuned on the same training data, exhibits relatively higher n-gram overlap scores and sentence similarity, while achieving moderate BERTScore, suggesting a tendency toward surface-level fidelity. Subsequent to Direct Preference Optimization (DPO) (known in the art), trained on the train split of the DPO dataset and evaluated on its test split, Llama-3.2-1B (FIG. 7B) maintained its profile of high semantic similarity, whereas SmolLM-135M (FIG. 7E) displays balanced improvements across both lexical and semantic metrics, reflecting effective alignment tuning via reward modeling. Following Retrieval-Augmented Instruction Tuning (RAIT) (known in the art), which was performed using the train splits of the Local and Global RAIT datasets and evaluated on their respective test splits, Llama-3.2-1B (FIG. 7C) continues to show dominant semantic scores relative to n-gram metrics.

SmolLM-135M (FIG. 7F) exhibits comparatively lower scores across most metrics, with sentence similarity remaining the strongest signal, suggesting diminished generalization capacity under retrieval-augmented long-context settings. These plots provide phase-by-phase performance diagnostics, highlighting how successive fine-tuning regimes induce distinct response behaviors across models in terms of semantic coherence, lexical fidelity, and alignment with training objectives. In addition, a systematic evaluation of how fine-tuning (FT) and Graph Retrieval-Augmented Generation (Graph RAG) affect qualitative performance across six language model variants was conducted, comprising two model architectures at different scales: the larger Llama-3.2-1B and more compact SmolLM2-135M. Each model variant represents a distinct configuration: (a) Llama-3.2-1B with both FT and Graph RAG (W/FT W/Graph RAG), (b) Llama-3.2-1B with FT but without Graph RAG (W/FT W/o Graph RAG), (c) Llama-3.2-1B without either FT or Graph RAG (W/o FT W/o Graph RAG), (d) Llama-3.2-1B without FT but with Graph RAG (W/o FT W/Graph RAG), (e) SmolLM2-135M with both FT and Graph RAG (W/FT W/Graph RAG), and (f) SmolLM2-135M with FT but without Graph RAG (W/FT W/o Graph RAG).

FIGS. 8A through 8E illustrates a qualitative evaluation of six model configurations on a 1.5K QA-pair out-of-distribution (OOD) benchmark, constructed independently of all synthetic training datasets (Factual QA (known in the art), SynDIP (known in the art), LogiCore (known in the art), DPO (known in the art), and RAIT (known in the art)), according to some embodiments of the present disclosure.

Framework generated responses are rigorously assessed using the NVIDIA^{®} Nemotron-4-340B reward model across five key qualitative dimensions: helpfulness (measuring practical utility), correctness (factual accuracy), coherence (logical flow), complexity (depth of content), and verbosity (response length), with detailed results presented in FIGS. 8A through 8E. The evaluation reveals several important findings regarding model scale and methodological impact. Among Llama-3.2-1B variants, the FT (Fine tuning) +RAG configuration (variant a) demonstrates superior performance, achieving the highest scores in correctness and complexity by effectively combining fine-tuned capabilities with retrieved knowledge, though this comes with increased verbosity due to the incorporation of supplementary content from the knowledge graph.

The Fine-tuning (FT)-only variant (b) maintains strong performance in coherence and helpfulness but shows limitations in knowledge-intensive tasks without retrieval support. Notably, even without fine-tuning, the Graph RAG-enabled Llama variant (d) outperforms the baseline (c) in correctness, demonstrating that retrieval augmentation can partially compensate for the absence of task-specific tuning. However, the complete absence of both methods (variant c) results in the weakest performance, highlighting the limitations of relying solely on pretrained knowledge. For the smaller SmolLM2- 135M models, Graph RAG improves correctness (variant e versus f), but both configurations underperform relative to the corresponding Llama-3.2-1B variants across all metrics, notably in coherence and complexity. This performance gap underscores the importance of model scale in effectively utilizing both finetuning and retrieval augmentation. The results demonstrate that while FT substantially enhances overall response quality across all metrics by aligning the model with domain-specific requirements, Graph RAG provides complementary benefits primarily for factual accuracy. This combination proves particularly valuable in specialized domains like chemical process synthesis, where both task adaptation and external knowledge integration are crucial for a high-quality generation.

The experiments of the system 100 and method of the present disclosure conclusively shows that the optimal configuration-Llama-3.2- 1B with both FT and Graph RAG-achieves the most balanced performance across all evaluation dimensions, successfully integrating structured knowledge retrieval with fine-tuned language understanding capabilities while maintaining reasonable verbosity levels. These findings have important implications for deploying language models in technical domains where both factual precision and contextual understanding are paramount.

FIG. 9A illustrates model performance comparison on ChemEval database for PFD/PID generation, evaluated using the NVIDIA^{®}/Nemotron4-340B reward model (0-4 scale), according to some embodiments of the present disclosure. GPT-4o performs best across all metrics. Fine-tuned Llama-3.2 1B ranks second, with lower verbosity but higher variance. SmolLM2-135M scores lowest overall, though it matches Llama in complexity and verbosity.

FIG. 9B illustrates a comparison of fine-tuned Llama-3.2 1B (known in the art) and SmolLM2-135M (known in the art) on BLEU (Bilingual Evaluation Understudy) (known in the art), METEOR (Metric for Evaluation of Translation with Explicit Ordering) (known in the art), ROUGE (Recall-Oriented Understudy for Gisting Evaluation) (known in the art), SacreBLEU (known in the art), BERTScore (Bidirectional Encoder Representations from Transformers) (known in the art), and similarity for ChemEval database, according to some embodiments of the present disclosure.

Existing methods are not designed to auto-generate PFDs or PIDs for industrial-scale chemical production processes. The present disclosure provides an integrated framework leveraging knowledge graph-based retrieval augmentation, domain-specific SLM fine-tuning pipelines, comprehensive inference optimizations, and feedback-driven refinement. The proposed approach of the present disclosure yields robust performance on complex reasoning tasks and demonstrates effective generalization via the generation of plausible, simulator-validated process descriptions for previously unseen chemicals.

The written description describes the subject matter herein to enable any person skilled in the art to make and use the embodiments. The scope of the subject matter embodiments is defined by the claims and may include other modifications that occur to those skilled in the art. Such other modifications are intended to be within the scope of the claims if they have similar elements that do not differ from the literal language of the claims or if they include equivalent elements with insubstantial differences from the literal language of the claims.

It is noted that embodiments described herein are discussed in the context of a Large Language Model (LLM) / Artificial Intelligence (AI) model / Machine Learning (ML) model and/ or with a mentioned training data set. It is to be understood by a person having ordinary skill in the art or person skilled in the art that the referred AI/ML/LLM model(s) are exemplary and shall not be construed as limiting the scope of the present disclosure and they may be trained by any training dataset that meets the mentioned defining characteristics / or has characteristics that define the exemplary training dataset mentioned.

It is to be understood that the scope of the protection is extended to such a program and in addition to a computer-readable means having a message therein; such computer-readable storage means contain program-code means for implementation of one or more steps of the method, when the program runs on a server or mobile device or any suitable programmable device. The hardware device can be any kind of device which can be programmed including e.g., any kind of computer like a server or a personal computer, or the like, or any combination thereof. The device may also include means which could be e.g., hardware means like e.g., an application-specific integrated circuit (ASIC), a field-programmable gate array (FPGA), or a combination of hardware and software means, e.g., an ASIC and an FPGA, or at least one microprocessor and at least one memory with software processing components located therein. Thus, the means can include both hardware means and software means. The method embodiments described herein could be implemented in hardware and software. The device may also include software means. Alternatively, the embodiments may be implemented on different hardware devices, e.g., using a plurality of CPUs.

The embodiments herein can comprise hardware and software elements. The embodiments that are implemented in software include but are not limited to, firmware, resident software, microcode, etc. The functions performed by various components described herein may be implemented in other components or combinations of other components. For the purposes of this description, a computer-usable or computer readable medium can be any apparatus that can comprise, store, communicate, propagate, or transport the program for use by or in connection with the instruction execution system, apparatus, or device.

The illustrated steps are set out to explain the exemplary embodiments shown, and it should be anticipated that ongoing technological development will change the manner in which particular functions are performed. These examples are presented herein for purposes of illustration, and not limitation. Further, the boundaries of the functional building blocks have been arbitrarily defined herein for the convenience of the description. Alternative boundaries can be defined so long as the specified functions and relationships thereof are appropriately performed. Alternatives (including equivalents, extensions, variations, deviations, etc., of those described herein) will be apparent to persons skilled in the relevant art(s) based on the teachings contained herein. Such alternatives fall within the scope of the disclosed embodiments. Also, the words "comprising," "having," "containing," and "including," and other similar forms are intended to be equivalent in meaning and be open ended in that an item or items following any one of these words is not meant to be an exhaustive listing of such item or items, or meant to be limited to only the listed item or items. It must also be noted that as used herein and in the appended claims, the singular forms "a," "an," and "the" include plural references unless the context clearly dictates otherwise.

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., be non-transitory. Examples include random access memory (RAM), read-only memory (ROM), volatile memory, nonvolatile memory, hard drives, CD ROMs, DVDs, flash drives, disks, and any other known physical storage media.

It is intended that the disclosure and examples be considered as exemplary only, with a true scope of disclosed embodiments being indicated by the following claims.

## Claims

1. A processor implemented method (300), comprising:
receiving (302), via one or more hardware processors, a query specific to at least one of a process flow diagram and a piping and instrumentation diagram description, from a user;
filtering (304), via the one or more hardware processors, the received query by passing through guardrails of one or more Large Language Models (LLMs), if the received user query includes an irrelevant information;
retrieving (306), via the one or more hardware processors, a context from a Memory database and a Graph database, based on the filtered query, using one or more fine-tuned Small Language Models (SLMs);
generating (308), via the one or more hardware processors, an initial enhanced response using a test-time inference scaling, wherein the test-time inference scaling comprises:
(i) generating, via the one or more fine-tuned SLMs a plurality of diverse candidate responses based on the query and the retrieved context;
(ii) selecting an improved preferred candidate response from the plurality of diverse candidate responses based on at least one of a confidence-weighted entropy scoring or a self-reflection based revision to enhance a factual accuracy and a reliability of the initial enhanced response; and
(iii) generating the initial enhanced response based on the improved preferred candidate response;
performing iteratively (310), via the one or more hardware processors, till a predefined number of iterations:
evaluating, by using a Critique-Agent, the generated initial enhanced response, using one or more feedback mechanisms which includes:
(i) providing, by using a SLM-as-a-judge, a first feedback including an identification of one or more potential errors, one or more inconsistencies, or one or more areas of improvement in the generated initial enhanced response; and
(ii) providing, by using a Reward-model-as-a-judge, a second feedback including a scalar score reflecting the quality of the generated initial enhanced response;
refining (312), via the one or more hardware processors, the generated initial enhanced response based on at least one of the first feedback from the SLM-as-a-judge and the second feedback from the Reward-model-as-a-judge; and
generating (314), via the one or more hardware processors, a final response to the query, based on the refinement.

2. The processor implemented method as claimed in claim 1, wherein the irrelevant information from a user query comprises at least one of a security threat, a privacy invasion, an Intellectual Property (IP) infringement, a hate speech, and a code interpreter abuse.

3. The processor implemented method as claimed in claim 1, wherein a process associated with the generation of the initial enhanced response is optimized for speed and efficiency by applying at least one of a structural pruning, a FlashAttention, a Paged KV Caching, and a Lookahead Decoding.

4. The processor implemented method as claimed in claim 1, wherein the SLMs are fine-tuned using the following steps:
(i) performing an initial Direct Preference Optimization (DPO) alignment by training the SLMs using a DPO algorithm on a synthetically generated DPO dataset comprising the process flow diagram and the piping and instrumentation diagram description;
(ii) fine-tuning the SLMs, subsequent to the initial DPO alignment, using at least one of the following:
(a) performing an instruction tuning using one or more synthetically generated datasets to enable the SLMs to learn (i) a domain-specific factual knowledge, (ii) a logical reasoning, (iii) a multi-step chain-of-thought reasoning, (iv) a sensor and instrumentation planning, (v) a comparative process analysis, and (vi) an error detection and correction, associated with the process flow diagram and the piping and instrumentation diagram description; or
(b) training the SLMs using a Group Relative Policy Optimization (GRPO) reinforcement learning, wherein:
(i) the SLMs generate a group of candidate responses for one or more tasks related to the process flow diagram and the piping and instrumentation diagram description;
(ii) the group of candidate responses are evaluated using a composite reward function that combines a plurality of metrics relevant to a quality of generating the process flow diagram and the piping and instrumentation diagram description; and
(iii) updating one or more parameters of the SLMs to increase a probability of generating one or more responses which receive a higher composite reward compared to a plurality of responses within the group of candidate responses.

5. A system (100), comprising:
a memory (104) storing instructions;
one or more communication interfaces (112); and
one or more hardware processors (102) coupled to the memory (104) via the one or more communication interfaces (112), wherein the one or more hardware processors (102) are configured by the instructions to:
receive a query specific to at least one of a process flow diagram and a piping and instrumentation diagram description, from a user;
filter the received query by passing through guardrails of one or more Large Language Models (LLMs), if the received user query includes an irrelevant information;
retrieve a context from a Memory database and a Graph database, based on the filtered query, using one or more fine-tuned Small Language Models (SLMs);
generate an initial enhanced response using a test-time inference scaling, wherein the test-time inference scaling comprises:
(i) generating, via the one or more fin-tuned SLMs a plurality of diverse candidate responses based on the query and the retrieved context;
(ii) selecting an improved preferred candidate response from the plurality of diverse candidate responses based on at least one of a confidence-weighted entropy scoring or a self-reflection based revision to enhance a factual accuracy and a reliability of the initial enhanced response; and
(iii) generating the initial enhanced response based on the improved preferred candidate response;
performing iteratively till a predefined number of iterations:
evaluating, by using a Critique-Agent, the generated initial enhanced response, using one or more feedback mechanisms which includes:
(i) providing, by using a SLM-as-a-judge, a first feedback including an identification of one or more potential errors, one or more inconsistencies, or one or more areas of improvement in the generated initial enhanced response; and
(ii) predicting, by using a Reward-model-as-a-judge, a second feedback including a scalar score reflecting the quality of the generated initial enhanced response;
refine the generated initial enhanced response based on at least one of the first feedback from the SLM-as-a-judge and the second feedback from the Reward-model-as-a-judge; and
generate a final response to the query, based on the refinement.

6. The system as claimed in claim 5, wherein the irrelevant information from a user query comprises at least one of a security threat, a privacy invasion, an Intellectual Property (IP) infringement, a hate speech, and a code interpreter abuse.

7. The system as claimed in claim 5, wherein a process associated with the generation of the initial enhanced response is optimized for speed and efficiency by applying at least one of a structural pruning, a FlashAttention, a Paged KV Caching, and a Lookahead Decoding.

8. The system as claimed in claim 5, wherein the SLMs are fine-tuned using the following steps:
(i) performing an initial Direct Preference Optimization (DPO) alignment by training the SLMs using a DPO algorithm on a synthetically generated DPO dataset comprising the process flow diagram and the piping and instrumentation diagram description;
(ii) fine-tuning the SLMs, subsequent to the initial DPO alignment, using at least one of the following:
(a) performing an instruction tuning using one or more synthetically generated datasets to enable the SLMs to learn (i) a domain-specific factual knowledge, (ii) a logical reasoning, (iii) a multi-step chain-of-thought reasoning, (iv) a sensor and instrumentation planning, (v) a comparative process analysis, and (vi) an error detection and correction, associated with the process flow diagram and the piping and instrumentation diagram description; or
(b) training the SLMs using a Group Relative Policy Optimization (GRPO) reinforcement learning, wherein:
(i) the SLMs generate a group of candidate responses for one or more tasks related to the process flow diagram and the piping and instrumentation diagram description;
(ii) the group of candidate responses are evaluated using a composite reward function that combines a plurality of metrics relevant to a quality of generating the process flow diagram and the piping and instrumentation diagram description; and
(iii) updating one or more parameters of the SLMs to increase a probability of generating one or more responses which receive a higher composite reward compared to a plurality of responses within the group of candidate responses.

9. One or more non-transitory machine-readable information storage mediums comprising one or more instructions which when executed by one or more hardware processors cause:
receiving a query specific to at least one of a process flow diagram and a piping and instrumentation diagram description, from a user;
filtering the received query by passing through guardrails of one or more Large Language Models (LLMs), if the received user query includes an irrelevant information;
retrieving a context from a Memory database and a Graph database, based on the filtered query, using one or more fine-tuned Small Language Models (SLMs);
generating an initial enhanced response using a test-time inference scaling, wherein the test-time inference scaling comprises:
(i) generating, via the one or more fine-tuned SLMs a plurality of diverse candidate responses based on the query and the retrieved context;
(ii) selecting an improved preferred candidate response from the plurality of diverse candidate responses based on at least one of a confidence-weighted entropy scoring or a self-reflection based revision to enhance a factual accuracy and a reliability of the initial enhanced response; and
(iii) generating the initial enhanced response based on the improved preferred candidate response;
performing iteratively till a predefined number of iterations:
evaluating, by using a Critique-Agent, the generated initial enhanced response, using one or more feedback mechanisms which includes:
(i) providing, by using a SLM-as-a-judge, a first feedback including an identification of one or more potential errors, one or more inconsistencies, or one or more areas of improvement in the generated initial enhanced response; and
(ii) providing, by using a Reward-model-as-a-judge, a second feedback including a scalar score reflecting the quality of the generated initial enhanced response;
refining the generated initial enhanced response based on at least one of the first feedback from the SLM-as-a-judge and the second feedback from the Reward-model-as-a-judge; and
generating a final response to the query, based on the refinement.

10. The one or more non-transitory machine-readable information storage mediums of claim 9, wherein the irrelevant information from a user query comprises at least one of a security threat, a privacy invasion, an Intellectual Property (IP) infringement, a hate speech, and a code interpreter abuse.

11. The one or more non-transitory machine-readable information storage mediums of claim 9, wherein a process associated with the generation of the initial enhanced response is optimized for speed and efficiency by applying at least one of a structural pruning, a FlashAttention, a Paged KV Caching, and a Lookahead Decoding.

12. The one or more non-transitory machine-readable information storage mediums of claim 9, wherein the SLMs are fine-tuned using the following steps:
(i) performing an initial Direct Preference Optimization (DPO) alignment by training the SLMs using a DPO algorithm on a synthetically generated DPO dataset further comprising the process flow diagram and the piping and instrumentation diagram description;
(ii) fine-tuning the SLMs, subsequent to the initial DPO alignment, using at least one of the following:
(a) performing an instruction tuning using one or more synthetically generated datasets to enable the SLMs to learn (i) a domain-specific factual knowledge, (ii) a logical reasoning, (iii) a multi-step chain-of-thought reasoning, (iv) a sensor and instrumentation planning, (v) a comparative process analysis, and (vi) an error detection and correction, associated with the process flow diagram and the piping and instrumentation diagram description; or
(b) training the SLMs using a Group Relative Policy Optimization (GRPO) reinforcement learning, wherein:
(i) the SLMs generate a group of candidate responses for one or more tasks related to the process flow diagram and the piping and instrumentation diagram description;
(ii) the group of candidate responses are evaluated using a composite reward function that combines a plurality of metrics relevant to a quality of generating the process flow diagram and the piping and instrumentation diagram description; and
(iii) updating one or more parameters of the SLMs to increase a probability of generating one or more responses which receive a higher composite reward compared to a plurality of responses within the group of candidate responses.
